(19) **Europäisches Patentamt / European Patent Office / Office européen des brevets**

(11) **EP 4 760 310 A1**

(12) **EUROPEAN PATENT APPLICATION**
published in accordance with Art. 153(4) EPC

(43) Date of publication:
**17.06.2026 Bulletin 2026/25**

(21) Application number: **24907693.6**

(22) Date of filing: **12.09.2024**

(51) International Patent Classification (IPC):
*G01R 31/392* (2019.01)   *G01R 19/00* (2006.01)
*G01R 31/3828* (2019.01)   *G01R 19/165* (2006.01)

(52) Cooperative Patent Classification (CPC):
**G01R 19/00; G01R 19/165; G01R 31/3828;
G01R 31/392; Y02E 60/10**

(86) International application number:
**PCT/KR2024/013934**

(87) International publication number:
**WO 2025/135408 (26.06.2025 Gazette 2025/26)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **18.12.2023 KR 20230184929**

(71) Applicant: **LG Energy Solution, Ltd.
Seoul 07335 (KR)**

(72) Inventors:
• **PARK, Jun Oh
Daejeon 34122 (KR)**
• **PARK, Jung Uk
Daejeon 34122 (KR)**
• **CHOI, Jung Hwan
Daejeon 34122 (KR)**
• **BYUN, Ha Eun
Daejeon 34122 (KR)**
• **KWON, Kyu Hwan
Daejeon 34122 (KR)**

(74) Representative: **Goddar, Heinz J.
Boehmert & Boehmert
Anwaltspartnerschaft mbB
Pettenkoferstrasse 22
80336 München (DE)**

(54) **BATTERY DIAGNOSIS DEVICE AND METHOD FOR OPERATING SAME**

(57)    A battery diagnosis apparatus according to an embodiment disclosed herein includes an obtaining unit configured to obtain time-series data related to states of a plurality of battery cells included in a battery module, a voltage diagnosing unit configured to calculate a long-short term voltage moving average difference of each battery cell based on the time-series data and diagnose voltage abnormality of each battery cell based on the long-short term voltage moving average difference, a capacity diagnosing unit configured to calculate a state of health (SOH) deviation of each battery cell based on the time-series data and diagnose capacity abnormality of each battery cell based on the SOH deviation, and a detecting unit configured to detect an abnormal battery cell based on a diagnosis result of at least one of the voltage diagnosing unit or the capacity diagnosing unit.

FIG.1

EP 4 760 310 A1

## Description

## Technical Field

## CROSS-REFERENCE TO RELATED APPLICATION

This application claims priority to and the benefit of Korean Patent Application No. 10-2023-0184929 filed in the Korean Intellectual Property Office on December 18, 2023, the entire content of which is incorporated herein by reference.

## TECHNICAL FIELD

Embodiments disclosed herein relate to a battery diagnosis apparatus and an operating method thereof.

## Background Art

Recently, research and development of secondary batteries have been actively performed. Herein, the secondary batteries, which are chargeable/-dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

Furthermore, the secondary battery is generally used as a battery pack including a battery module where a plurality of battery cells are connected to one another in series and/or in parallel. The secondary battery may be used as a battery rack including a plurality of battery modules and a rack frame receiving the battery modules.

The battery cell, the battery module, the battery pack, or the battery rack may be used in various devices. For example, the batteries may be used not only for mobile devices such as mobile phones, laptop computers, smart phones, smart pads, etc., but also in the field of vehicles (electric vehicles (EV), hybrid electric vehicles (HEV), plug-in HEV (PHEV)) driven with electricity, large-volume energy storage systems (ESS), etc.

These batteries may be managed and controlled in terms of states and operations thereof by a battery management system (BMS). The battery management system may be included together with a battery in one device.

The battery management system may also manage and control the battery in a state of being spaced apart from a device including the battery. For example, the battery management system may be implemented as a separate server device. In this case, the battery management system may collect battery data and vehicle data from the vehicle, etc., and manage and control the battery using the collected data.

Meanwhile, when a battery has a defect, the possibility of damage to devices (e.g., an EV, an ESS) including the battery may increase. Accordingly, there is a need for a scheme to reduce the possibility of damage to devices including a battery by detecting an abnormal state of the battery.

## Disclosure

## Technical Problem

Conventionally, to diagnose a defect of a battery, there has been an attempt to diagnose voltage abnormality by detecting an instantaneous change of a battery cell voltage. For example, a battery cell showing an instantaneous voltage change based on a cell voltage moving average may be diagnosed as a voltage-abnormal battery cell.

However, the instantaneous voltage change of the battery cell may originate from not only separation or contact of a negative tab or a positive tab, but also voltage measurement noise. That is, merely with voltage abnormality diagnosis, there is a possibility of false defection due to noise.

In this regard, a defect due to separation or contact of a negative tab or a positive tab of a battery cell may lead to instantaneous capacity reduction or cause capacity deviation, and capacity abnormality diagnosis may have a less influence of voltage measurement noise than voltage abnormality diagnosis.

Embodiments disclosed herein are made to complement the problems of a voltage abnormality diagnosis method and provide a battery diagnosis apparatus and an operating method thereof in which capacity abnormality diagnosis is performed in addition to voltage abnormality diagnosis for a battery cell so as to reduce a false detection rate due to voltage measurement noise, thereby detecting an abnormality battery cell.

Technical problems of the embodiments disclosed herein are not limited to the aforementioned technical problems, and other unmentioned technical problems would be clearly understood by those of ordinary skill in the art from the following description.

## Technical Solution

A battery diagnosis apparatus according to an embodiment disclosed herein includes an obtaining unit configured to obtain time-series data related to states of a plurality of battery cells included in a battery module, a voltage diagnosing unit configured to calculate a long-short term voltage moving average difference of each battery cell based on the time-series data and diagnose voltage abnormality of each battery cell based on the long-short term voltage moving average difference, a capacity diagnosing unit configured to calculate a state of health (SOH) deviation of each battery cell based on the time-series data and diagnose capacity abnormality of each battery cell based on the SOH deviation, and a detecting unit configured to detect an abnormal battery cell based on a diagnosis result of at least one of the voltage diagnosing unit or the capacity diagnosing unit.

In the battery diagnosis apparatus according to an embodiment disclosed herein, the voltage diagnosing unit may be further configured to calculate a short-term voltage moving average of each battery cell based on a first time window, calculate a long-term voltage moving average of each battery cell based on a second time window having a longer time length than the first time window, and calculate the long-short term voltage moving average difference corresponding to a difference between the short-term voltage moving average and the long-term voltage moving average, for each battery cell.

In the battery diagnosis apparatus according to an embodiment disclosed herein, the voltage diagnosing unit may be further configured to calculate a voltage diagnosis deviation corresponding to a deviation between an average of long-short term voltage moving average differences of the plurality of battery cells and the long-short term voltage moving average difference of each battery cell, for each battery cell and diagnose voltage abnormality of each battery cell based on the voltage diagnosis deviation.

In the battery diagnosis apparatus according to an embodiment disclosed herein, the voltage diagnosing unit may be further configured to determine a statistical variable threshold value depending on a standard deviation for voltage diagnosis deviations of the plurality of battery cells, calculate a filter diagnosis value by filtering the voltage diagnosis deviation based on the statistical variable threshold value, for each battery cell, and diagnose voltage abnormality of each battery cell based on the filter diagnosis value.

In the battery diagnosis apparatus according to an embodiment disclosed herein, the voltage diagnosing unit may be further configured to calculate a normalized value of the long-short term voltage moving average difference as a normalized voltage diagnosis deviation, for each battery cell and diagnose voltage abnormality of each battery cell based on the normalized voltage diagnosis deviation.

In the battery diagnosis apparatus according to an embodiment disclosed herein, the voltage diagnosing unit may be further configured to determine a statistical variable threshold value depending on a standard deviation for normalized voltage diagnosis deviations of the plurality of battery cells, calculate a filter diagnosis value by filtering the normalized voltage diagnosis deviation based on the statistical variable threshold value, for each battery cell, and diagnose voltage abnormality of each battery cell based on the filter diagnosis value.

In the battery diagnosis apparatus according to an embodiment disclosed herein, the voltage diagnosing unit may be further configured to calculate a moving average diagnosis value by recursively repeating processes (i) to (iii) at least once for each battery cell, the processes (i) to (iii) including (i) calculating a first moving average corresponding to a short-term moving average of a normalized voltage diagnosis deviation of each battery cell and a second moving average corresponding to a long-term moving average, (ii) calculating a long-short term moving average difference corresponding to a difference between the first moving average and the second moving average, for each battery cell, and (iii) calculating a normalized value of the long-short term moving average difference as a moving average diagnosis value, for each battery cell, and diagnose voltage abnormality of each battery cell based on the moving average diagnosis value.

In the battery diagnosis apparatus according to an embodiment disclosed herein, the capacity diagnosing unit may be further configured to calculate a state of health (SOH) of each battery cell based on the time-series data and calculate, for each battery cell, the SOH deviation corresponding to a deviation between an SOH median value or SOH average of the plurality of battery cells and an SOH of each battery cell.

In the battery diagnosis apparatus according to an embodiment disclosed herein, the capacity diagnosing unit may be further configured to calculate a state of health (SOH) of each battery cell based on the time-series data, calculate an SOH moving average of each battery cell based on a third time window, and calculate, for each battery cell, the SOH deviation corresponding to a deviation between an average of SOH moving averages of the plurality of battery cells and an SOH moving average of each battery cell.

In the battery diagnosis apparatus according to an embodiment disclosed herein, the capacity diagnosing unit may be further configured to calculate a state of charge (SOC) difference of each battery cell before and after a charging period, based on the time-series data, calculate a current integration value of each battery cell in the charging period, based on the time-series data, calculate, for each battery cell, SOHc indicating SOH regarding a capacity of each battery cell, based on the SOC difference, the current integration value, and an initial capacity of each battery cell, and calculate the SOH deviation of each battery cell, based on SOHc.

In the battery diagnosis apparatus according to an embodiment disclosed herein, the capacity diagnosing unit may be further configured to diagnose capacity abnormality for at least one battery cell diagnosed as having voltage abnormality by the voltage diagnosing unit.

In the battery diagnosis apparatus according to an embodiment disclosed herein, the detecting unit may be further configured to detect, as the abnormal battery cell, a battery cell diagnosed as having capacity abnormality by the capacity diagnosing unit.

In the battery diagnosis apparatus according to an embodiment disclosed herein, the detecting unit may be further configured to detect, as the abnormal battery cell, a battery cell diagnosed as having voltage abnormality by the voltage diagnosing unit and having capacity abnormality by the capacity diagnosing unit.

A battery diagnosis method according to an embodiment disclosed herein includes obtaining time-series data related to states of a plurality of battery cells included in a battery module, calculating a long-short term voltage moving average difference of each battery cell based on the time-series data and diagnose voltage abnormality of each battery cell based on the long-short term voltage moving average difference, calculating a state of health (SOH) deviation of each battery cell based on the time-series data and diagnosing capacity abnormality of each battery cell based on the SOH deviation, and detecting an abnormal battery cell based on at least one of diagnosis results of at least one of the voltage diagnosing unit or the capacity diagnosing unit.

In the battery diagnosis method according to an embodiment disclosed herein, the diagnosing of capacity abnormality for each battery cell may include diagnosing capacity abnormality for at least one battery cell diagnosed as having voltage abnormality, and the detecting of the abnormal battery cell may include detecting, as the abnormal battery cell, a battery cell diagnosed as having capacity abnormality.

## Advantageous Effects

According to embodiments disclosed herein, by reducing false defection due to voltage measurement noise in an abnormal battery cell detection process, the accuracy of battery diagnosis may be improved.

In addition, various effects identified directly or indirectly through this document may be provided.

## Description of Drawings

FIG. 1 is a block diagram of a battery diagnosis apparatus according to an embodiment.

FIG. 2 is a graph showing voltage time-series data of a plurality of battery cells, obtained by a battery diagnosis apparatus according to an embodiment.

FIGS. 3A to 3G are graphs for describing a process, performed by a battery diagnosis apparatus according to an embodiment, of diagnosing voltage abnormality of each battery cell from voltage time-series data of FIG. 2.

FIGS. 4A and 4B are graphs for describing a process, performed by a battery diagnosis apparatus according to an embodiment, of diagnosing capacity abnormality of each battery cell.

FIG. 5 is an operating flowchart of a battery diagnosis apparatus according to an embodiment.

FIG. 6 is an operation flowchart of a battery diagnosis apparatus according to an embodiment.

FIG. 7 is an operation flowchart of a battery diagnosis apparatus according to an embodiment.

FIG. 8 is an operation flowchart of a battery diagnosis apparatus according to an embodiment.

FIG. 9 is an operation flowchart of a battery diagnosis apparatus according to an embodiment.

FIG. 10 is an operation flowchart of a battery diagnosis apparatus according to an embodiment.

## Mode for Invention

Hereinafter, various embodiments of the present disclosure will be described with reference to the accompanying drawings. However, the description is not intended to limit the present disclosure to particular embodiments, and it should be construed as including various modifications, equivalents, and/or alternatives according to the embodiments of the present disclosure.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st", "2nd," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly), wirelessly, or via a third element).

According to various embodiments of the disclosure, each of the above-described components (e.g., a module or program) may include a single entity or a plurality of entities, some of which may be separately disposed on other components. According to various embodiments of the disclosure, one or more of the above-described components or operations may be omitted or one or more other components or operations may be added. Alternatively or additionally, a plurality of components (e.g., modules or programs) may be integrated into one component. In this case, the integrated component may perform one or more functions of each of the plurality of components in a manner that is the same as or similar to a corresponding component of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

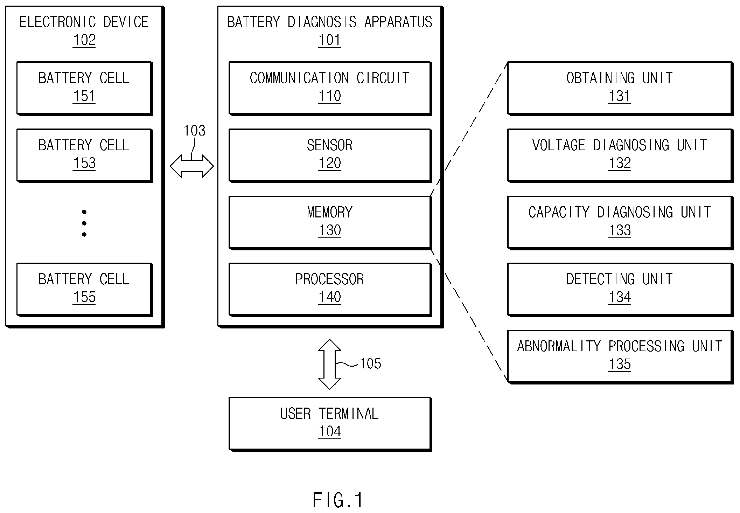

FIG. 1 is a block diagram of a battery diagnosis apparatus according to an embodiment.

The battery diagnosis apparatus 101 described below may be implemented as a battery management system (BMS) in an electronic device 102, and may also be implemented with various external devices such as a server, a cloud, a charger, a charger/discharger, etc.

Referring to FIG. 1, the battery diagnosis apparatus 101 may be wiredly and/or wirelessly connected to an electronic device 102 and a user terminal 104.

According to an embodiment, connection 103 between the battery diagnosis apparatus 101 and the electronic device 102 may be communication connection through a wired and/or wireless network. In an embodiment, the wired network may be based on a local area network (LAN) communication or a power-line communication. In an embodiment, the wireless network may be based on a short-range communication network (e.g., Bluetooth, Wireless Fidelity (WiFi), or Infrared Data Association (IrDA)) or a remote-range communication network (e.g., a cellular network, a 4th-Generation (4G) network, a 5th-Generation (5G) network).

According to another embodiment, the connection 103 between the battery diagnosis apparatus 101 and the electronic device 102 may be connection using a device-to-device communication scheme (e.g., a bus, a general-purpose input and output (GPIO), a serial peripheral interface (SPI), or a mobile industry processor interface (MIPI)).

According to an embodiment, the electronic device 102 may be a mobile device (e.g., a mobile phone, a laptop computer, a smart phone, a smart pad), an electric vehicle (e.g., an electric vehicle (EV), a hybrid EV (HEV), a plug-in HEV (PHEV), a fuel cell EV (FCEV)), an energy storage system (ESS), or a battery swapping system (BSS).

According to an embodiment, the electronic device 102 may include a plurality of battery cells 151, 153, and 155. Herein, each battery cell 151, 153, or 155 may be a single battery cell and may also be a cell group in which at least two battery cells are connected in parallel. According to an embodiment, the electronic device 102 may include at least one battery module and/or at least one battery pack including the plurality of battery cells 151, 153, and 155. For example, the plurality of battery cells 151, 153, and 155 may be included in one battery module or one battery pack.

According to an embodiment, connection 105 between the battery diagnosis apparatus 101 and the user terminal 104 may be communication connection through a wired and/or wireless network.

According to an embodiment, the user terminal 104 may be a mobile device (e.g., a mobile phone, a laptop computer, a smart phone, a smart pad), or a personal computer (PC). According to an embodiment, the battery diagnosis apparatus 101 may provide information related to a diagnosis result of the battery cells 151, 153, or 155 to the user terminal 104.

According to an embodiment, the battery diagnosis apparatus 101 may include a communication circuit 110, a sensor 120, a memory 130, and a processor 140. According to an embodiment, the battery diagnosis apparatus 101 shown in FIG. 1 may further include at least one component (e.g., a display, an input device, or an output device) in addition to the components shown in FIG. 1, or at least one component (e.g., the sensor 120) among the components shown in FIG. 1 may be omitted. For example, when the battery diagnosis apparatus 101 is implemented as a separate external electronic device from the electronic device 102, such as a server, a cloud, etc., the battery diagnosis apparatus 101 may obtain state information of the plurality of battery cells 151, 153, and 155 by using the communication circuit 110. In this case, the battery diagnosis apparatus 101 may not include the sensor 120.

According to an embodiment, the communication circuit 110 may establish a wired communication channel and/or a wireless communication channel between the battery diagnosis apparatus 101 and the electronic device 102 and/or the user terminal 104, and transmit and receive data to and from the electronic device 102 and/or the user terminal 104 through the established communication channel.

According to an embodiment, the sensor 120 may measure information (e.g., voltage, current, temperature, etc.,) related to states of the battery cells 151, 153, and 155 of the electronic device 102. For example, when the battery diagnosis apparatus 101 is implemented as a BMS in the electronic device, the battery diagnosis apparatus 101 may directly measure states of the plurality of battery cells 151, 153, and 155 by using the sensor 120.

According to an embodiment, the communication circuit 110 and/or the sensor 120 may obtain time-series data related to the states of the battery cells 151, 153, and 155. In an embodiment, the time-series data related to the states of the plurality of battery cells 151, 153, and 155 may include data indicating voltages, currents, resistances, states of charge (SOC), states of health (SOH), and/or temperatures of the plurality of battery cells 151, 153, and 155 with respect to time.

According to an embodiment, the memory 130 may include a volatile and/or a nonvolatile memory.

According to an embodiment, the memory 130 may store data used by at least one component (e.g., the processor 140) of the battery diagnosis apparatus 101. For example, the data may include software (or an instruction related thereto), input data, or output data. In an embodiment, the instruction, when executed by the processor 140, may cause the battery diagnosis apparatus 101 to perform operations defined by the instruction.

According to an embodiment, the memory 140 may include one or more software (e.g., an obtaining unit 131, a voltage diagnosing unit 132, a capacity diagnosing unit 133, a detecting unit 134, and an abnormality processing unit 135).

According to an embodiment, the processor 140 may include a central processing unit, an application processor, a graphic processing unit, a neural processing unit (NPU), an image signal processor, a sensor hub processor, or a communication processor.

According to an embodiment, the processor 140 may execute software (e.g., the obtaining unit 131, the voltage diagnosing unit 132, the capacity diagnosing unit 133, the detecting unit 134, and the abnormality processing unit 135) stored in the memory 130 to control at least one other component (e.g., a hardware or software component) of the battery diagnosis apparatus 101 connected to the processor 140 and perform various data processing or operations.

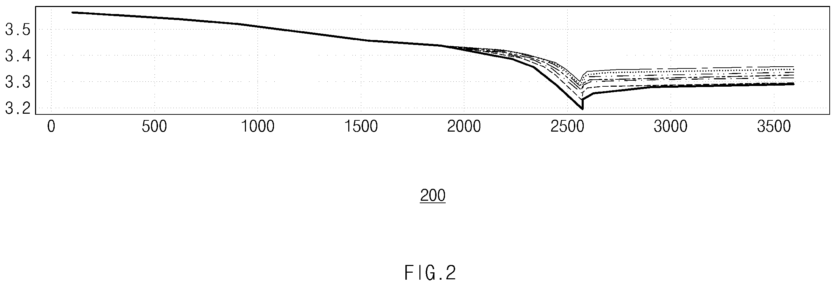

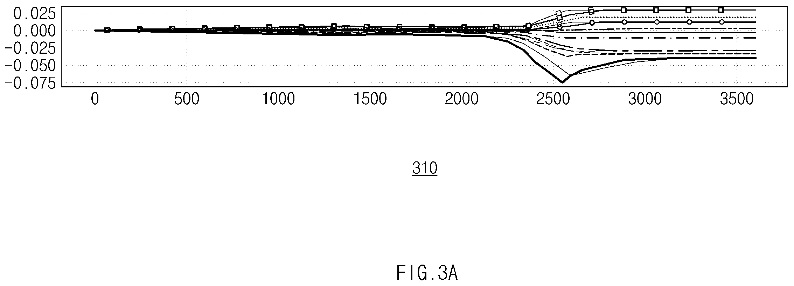

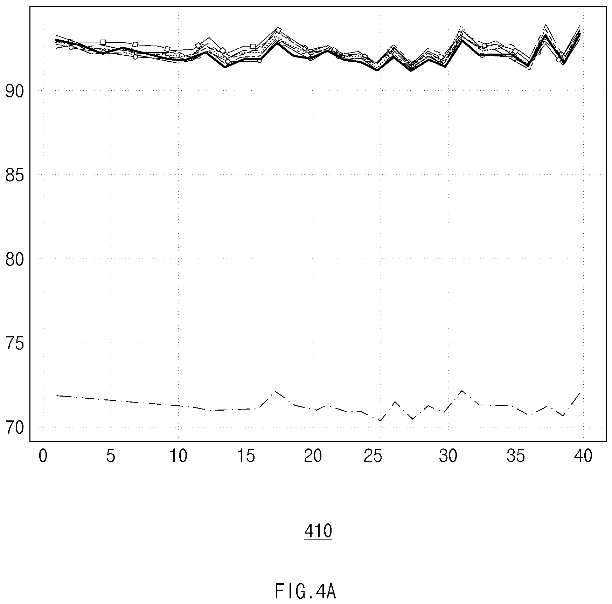

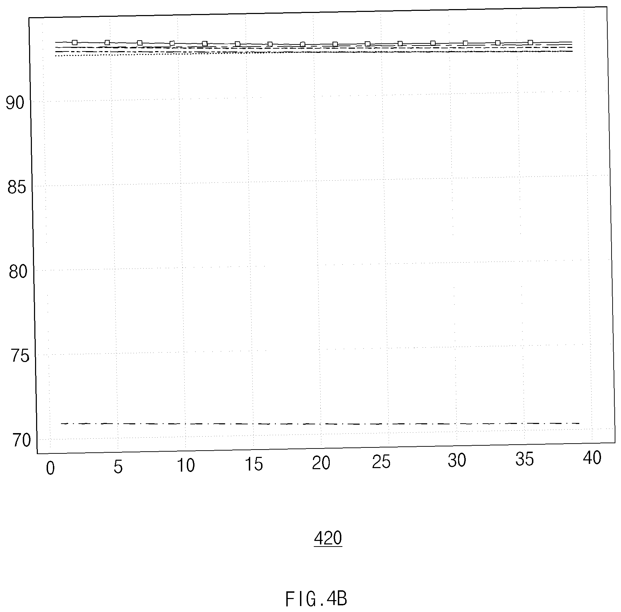

Hereinbelow, a method, performed by the battery diagnosis apparatus 101, of diagnosing abnormality of the plurality of battery cells 151, 153, and 155 through the obtaining unit 131, the voltage diagnosing unit 132, the capacity diagnosing unit 133, the detecting unit 134, and the abnormality processing unit 135 will be described with reference to FIGS. 2, 3A to 3G, 4A, and 4B. More specifically, a description will be made of a voltage abnormality diagnosis process of the battery diagnosis apparatus 101 with reference to FIGS. 3A to 3G and a capacity abnormality diagnosis a process of the battery diagnosis apparatus 101 with reference to FIGS. 4A and 4B.

FIG. 2 is a graph showing voltage time-series data of a plurality of battery cells, obtained by a battery diagnosis apparatus according to an embodiment. FIGS. 3A to 3G are graphs for describing a process, performed by a battery diagnosis apparatus according to an embodiment, of diagnosing voltage abnormality of each battery cell from voltage time-series data of FIG. 2. FIGS. 4A and 4B are graphs for describing a process, performed by a battery diagnosis apparatus according to an embodiment, of diagnosing capacity abnormality of each battery cell.

According to an embodiment, the obtaining unit 131 may obtain time-series data related to the states of the battery cells 151, 153, and 155. According to an embodiment, the obtaining unit 131 may obtain the time-series data by using the communication circuit 110 and/or the sensor 120.

According to an embodiment, the obtaining unit 131 may collect a signal related to states of the plurality of battery cells 151, 153, and 155 by using the communication circuit 110 and/or the sensor 120 every unit time and record state values (e.g., a voltage value, a current value, a temperature value, a resistance value, etc.) of the plurality of battery cells 151, 153, and 155. Herein, a unit time may be an integer multiple of a state signal reception period of the communication circuit 110 or a state measurement period of the sensor 120.

According to an embodiment, the obtaining unit 131 may generate time-series data indicating a change in the state values of the plurality of battery cells 151, 153, and 155 over time, based on the state values of the plurality of battery cells 151, 153, and 155, recorded in the memory 130. In this case, each time when the state values of the plurality of battery cells 151, 153, and 155 are obtained, the number of time-series data may increase by 1.

Referring to FIG. 2, voltage time-series data indicating a change in voltages of the plurality of battery cells (e.g., 151, 153, and 155), obtained by the obtaining unit 131, is illustrated in a graph 200. In the graph 200, a horizontal axis may indicate a time and a vertical axis may indicate a voltage.

Voltage Abnormality Diagnosis

According to an embodiment, the voltage diagnosing unit 132 may calculate a long-short term voltage moving average difference of each battery cell 151, 153, or 155 based on the time-series data obtained by the obtaining unit 131.

According to an embodiment, the voltage diagnosing unit 132 may calculate a voltage moving average of each of the plurality of battery cells 151, 153, and 155 every unit time by using one time window or two time windows. When two time windows are used, a time length of any one time window may be different from a time length of the other time window.

Herein, a time length of each time window may be an integer multiple of a unit time, and an end point of each time window may be the present point in time and a start point of each time window may be a point in time ahead of the present point in time by a predetermined time length.

Hereinbelow, for convenience of a description, a time window having a shorter time length between two time windows will be referred to as a first time window and a time window having a longer time length will be referred to as a second time window.

According to an embodiment, the voltage diagnosing unit 132 may calculate a short-term voltage moving average of each battery cell 151, 153, or 155 every unit time based on the first time window. The voltage diagnosing unit 132 may calculate a long-term voltage moving average of each battery cell 151, 153, or 155 every unit time based on the second time window. Herein, the moving average may mean any one of a simple moving average (SMA), a weighted moving average (WMA), or exponential moving average (EMA).

For example, an input factor in voltage moving average calculation may be a voltage value of each battery cell 151, 153, or 155 in a specific time window (e.g., the first time window or the second time window). In this case, the calculated voltage moving average may indicate a long-short term moving average for a voltage value of each battery cell 151, 153, or 155.

In another example, the input factor in voltage moving average calculation may be a deviation between a reference voltage for the plurality of battery cells 151, 153, and 155 and a voltage of each battery cell 151, 153, or 155 in a specific time window (e.g., the first time window or the second time window). Herein, the reference voltage may be determined from the plurality of battery cells 151, 153, and 155, and may be determined as an average value or a median value of voltage values of the plurality of battery cells 151, 153, and 155. In this case, the calculated voltage moving average may indicate a long-short term moving average for a voltage deviation of each battery cell 151, 153, or 155.

According to an embodiment, the voltage diagnosing unit 132 may compare a short-term change trend and a long-term change trend of a cell voltage every unit time based on a long-term voltage moving average and a short-term voltage moving average of each battery cell 151, 153, or 155 calculated every unit time.

Referring to FIG. 3A, a graph 310 is illustrated which shows a short-term voltage moving average line and a long-term voltage moving average line of the plurality of battery cells (e.g., 151, 153, and 155), calculated by the voltage diagnosing unit 132 from the voltage time-series data of FIG. 2. In the graph 310, a horizontal axis may indicate a time and a vertical axis may indicate a voltage moving average value.

In the graph 310, two moving average lines having the same shape, but expressed with different thicknesses may be respectively a short-term voltage moving average line and a long-term voltage moving average line of a specific battery cell, and indicate change histories of the short-term voltage moving average and the long-term voltage moving average of the battery cell. In moving average calculation of the graph 310, the time length of the first time window used may be 10 seconds and the time length of the second time window used may be 100 seconds, but the present disclosure is not limited thereto.

According to an embodiment, the voltage diagnosing unit 132 may calculate a long-short term voltage moving average difference corresponding to a difference between the short-term voltage moving average and the long-term voltage moving average for each battery cell 151, 153, or 155 every unit time. Herein, the long-short term voltage moving average difference may be a value obtained by subtracting the smaller one between the short-term voltage moving average and the long-term voltage moving average from the larger one.

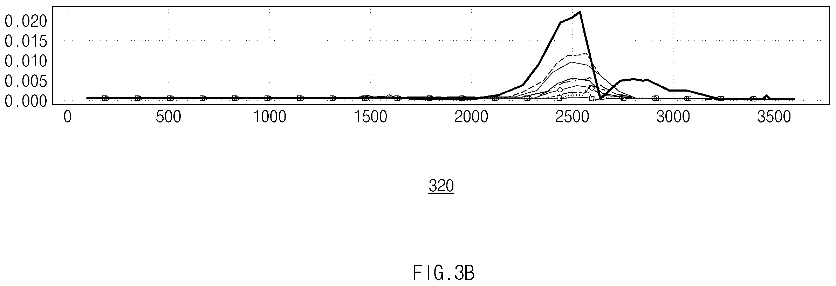

Referring to FIG. 3B, a graph 320 is illustrated which shows a long-short term voltage moving average difference of the plurality of battery cells (e.g., 151, 153, and 155), calculated by the voltage diagnosing unit 132 from the voltage moving average line of FIG. 3A. In the graph 320, a horizontal axis may indicate a time and a vertical axis may indicate a long-short term voltage moving average difference value.

A long-short term voltage moving average difference of a battery cell may depend on a short-term change history and a long-term change history of a cell voltage.

A temperature and a state of health (SOH) of the battery cell may constantly affect the cell voltage for not only a short term, but also a long term. Thus, the long-short term voltage moving average difference of the battery cell having no voltage abnormality may not be significantly different from long-short term voltage moving average differences of the other battery cells.

On the other hand, voltage abnormality suddenly occurring due to internal short-circuit and/or external short-circuit, etc., in a battery cell may affect the short-term voltage moving average more greatly than the long-term voltage moving average. As a result, the long-short term voltage moving average difference of the battery cell is quite different from the long-short term voltage moving average differences of the other battery cells having no voltage abnormality.

Thus, the long-short term voltage moving average difference of the battery cell may be an indicator required for voltage abnormality diagnosis.

According to an embodiment, the voltage diagnosing unit 132 may diagnose voltage abnormality of each battery cell 151, 153, or 155 based on the long-short term voltage moving average difference of each battery cell 151, 153, or 155.

According to an embodiment, the voltage diagnosing unit 132 may calculate a voltage diagnosis deviation of each battery cell 151, 153, or 155 every unit time based on the long-short term voltage moving average difference.

According to an embodiment, the voltage diagnosing unit 132 may calculate a voltage diagnosis deviation corresponding to a deviation between an average of long-short term voltage moving average differences of the plurality of battery cells 151, 153, and 155 and the long-short term voltage moving average difference of each battery cell 151, 153, or 155, for each battery cell 151, 153, or 155. In this case, the voltage diagnosing unit 132 may diagnose voltage abnormality of each battery cell 151, 153, or 155 based on the calculated voltage diagnosis deviation. For example, the voltage diagnosing unit 132 may diagnose, as a battery cell having voltage abnormality, a battery cell having the calculated voltage diagnosis deviation exceeding a preset threshold value (e.g., 0.015).

According to an embodiment, the voltage diagnosing unit 132 may calculate a normalized value of a long-short term voltage moving average difference as a normalized voltage diagnosis deviation every unit time for each battery cell 151, 153, or 155.

For example, the voltage diagnosing unit 132 may normalize the long-short term voltage moving average difference of each battery cell 151, 153, or 155 by using the average of the long-short term voltage moving average differences of the plurality of battery cells 151, 153, and 155. For example, the voltage diagnosing unit 132 may normalize the long-short term voltage moving average difference by performing a division operation (e.g., DSL/Dav in which DSL indicates the long-short term voltage moving average difference and Dav indicates the average) on the long-short term voltage moving average difference of each battery cell 151, 153, or 155 with the average.

In another example, the voltage diagnosing unit 132 may perform normalization through a log operation (e.g., Log(DSL) in which DSL indicates a long-short term voltage moving average difference) on the long-short term voltage moving average difference of each battery cell 151, 153, or 155.

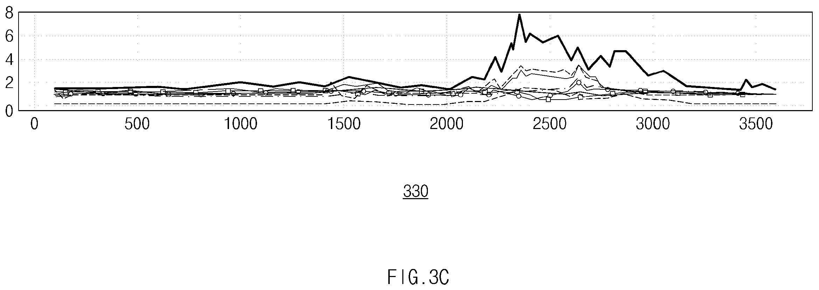

Referring to FIG. 3C, a graph 330 is illustrated which shows voltage diagnosis deviations of the plurality of battery cells (e.g., 151, 153, and 155) calculated by the voltage diagnosing unit 132 based on the long-short term voltage moving average difference of FIG. 3B. In the graph 330, an X axis may indicate a time and a vertical axis may indicate a voltage diagnosis deviation normalized by performing a division operation on the long-short term voltage moving average difference of each battery cell 151, 153, or 155 with the average.

According to the graph 330, it may be seen that a change in the long-short term voltage moving average difference of each battery cell is amplified with respect to the average through normalization of the long-short term voltage moving average difference. Thus, the voltage abnormality diagnosis of the battery cell may be performed more accurately.

According to an embodiment, the voltage diagnosing unit 132 may diagnose voltage abnormality of each battery cell 151, 153, or 155 by comparing the calculated voltage diagnosis deviation (or the normalized voltage diagnosis deviation) with a statistical variable threshold value.

According to an embodiment, the voltage diagnosing unit 132 may determine the statistical variable threshold value depending on a standard deviation for the voltage diagnosis deviations (or the normalized voltage diagnosis deviations) of the plurality of battery cells 151, 153, and 155 every unit time. For example, the voltage diagnosing unit 132 may determine the statistical variable threshold value based on Equation 1.

[Equation 1]

$$D_{threshold} = \beta * Sig(D_{diag})$$

In Equation 1, $D_{threshold}$ may indicate the statistical variable threshold value, $\beta$ may indicate a predetermined constant, and Sig may indicate a function for operating a standard deviation for the voltage diagnosis deviations of the plurality of battery cells 151, 153, and 155. $\beta$ may be a factor for determining diagnosis sensitivity and may be determined experimentally. $\beta$ may be appropriately determined through trials and errors to detect a corresponding battery cell as a voltage-abnormal cell when embodiments disclosed herein are performed on a cell group including the battery cell having voltage abnormality occurred therein. For example, $\beta$ may be set to at least 5, at least 6, at least 7, at least 8, or at least 9.

Meanwhile, the battery cell having voltage abnormality may have a voltage diagnosis deviation greater than a normal battery cell. Thus, a maximum value of a voltage diagnosis deviation may be excluded in calculation of $Sig(D_{diag})$ every unit time to improve the accuracy and reliability of diagnosis.

According to an embodiment, the voltage diagnosing unit 132 may calculate a filter diagnosis value by filtering the voltage diagnosis deviation (or the normalized voltage diagnosis deviation) of each battery cell 151, 153, or 155 based on the statistical variable threshold value. For example, the voltage diagnosing unit 132 may calculate one of two values as the filter diagnosis value, based on Equation 2.

[Equation 2]

$$D_{filter} = D_{diag} - D_{threshold} \ (IF \ D_{diag} > D_{threshold})$$

$$D_{filter} = 0 \ (IF \ D_{diag} \leq D_{threshold})$$

That is, the voltage diagnosing unit 132 may calculate a difference between the voltage diagnosis deviation and the statistical variable threshold value as the filter diagnosis value when the voltage diagnosis deviation (or the normalized voltage diagnosis deviation) is greater than the statistical variable threshold value. On the other hand, the voltage diagnosing unit 132 may calculate the filter diagnosis value as 0 when the voltage diagnosis deviation (or the normalized voltage diagnosis deviation) is less than or equal to the statistical variable threshold value.

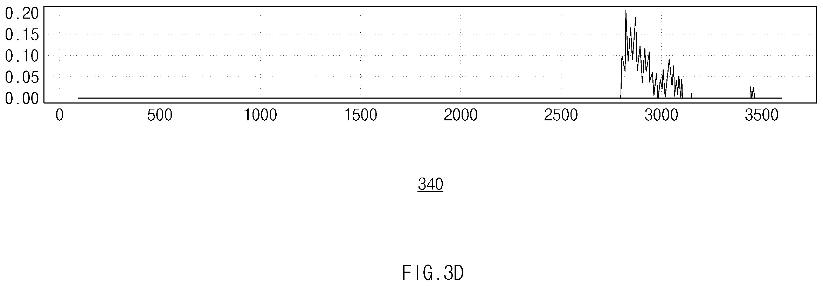

Referring to FIG. 3D, a graph 340 is illustrated which shows filter diagnosis values of the plurality of battery cells (e.g., 151, 153, and 155) calculated by the voltage diagnosing unit 132 based on the voltage diagnosis deviation and the statistical variable threshold value of FIG. 3C. In the graph 330, an X axis may indicate a time and a vertical axis may indicate a filter diagnosis value.

According to an embodiment, the voltage diagnosing unit 132 may diagnose voltage abnormality of each battery cell 151, 153, or 155 based on the calculated filter diagnosis value.

For example, the voltage diagnosing unit 132 may integrate a time period in which the filter diagnosis value is greater than (or greater than or equal to) a diagnosis threshold value (e.g., 0) for each battery cell 151, 153, or 155, and diagnose, as a battery cell having voltage abnormality, a battery cell for which a condition that an integration time is greater than (or greater than or equal to) a preset reference time is satisfied. The voltage diagnosing unit 132 may integrate a time period in which a condition that the filter diagnosis value is greater than (or greater than or equal to) the diagnosis threshold value is continuously satisfied. When there are a plurality of time periods, the voltage diagnosing unit 132 may independently calculate the integration time every time period.

In another example, the voltage diagnosing unit 132 may integrate the number of pieces of data included in the time period in which the filter diagnosis value is greater than (or greater than or equal to) the diagnosis threshold value (e.g., 0) from time-series data of the filter diagnosis value, and diagnose, as a battery cell having voltage abnormality, a battery cell for which a condition that a data integration value is greater than (or greater than or equal to) a preset reference count is satisfied. The voltage diagnosing unit 132 may integrate the number of pieces of data included in the time period in which the condition that the filter diagnosis value is greater than (or greater than or equal to) the diagnosis threshold value is continuously satisfied. When there are a plurality of time periods, the voltage diagnosing unit 132 may independently integrate the number of pieces of data of each time period.

According to an embodiment, the voltage diagnosing unit 132 may calculate a moving average diagnosis value of each battery cell 151, 153, or 155 based on the voltage diagnosis deviation (or the normalized voltage diagnosis deviation). The voltage diagnosing unit 132 may recursively perform a process of (i) calculating a first moving average corresponding to a short-term moving average of the voltage diagnosis deviation (or the normalized voltage diagnosis deviation) of each battery cell 151, 153, or 155 and a second moving average corresponding to a long-term moving average, a process of (ii) calculating a long-short term moving average difference corresponding to a difference between the first moving average and the second moving average for each battery cell 151, 153, or 155, and a process of (iii) calculating a normalized value of the long-short term moving average difference as a moving average diagnosis value for each battery cell 151, 153, or 155. That is, the voltage diagnosing unit 132 may replace the voltage time-series data of FIG. 2 with the normalized voltage diagnosis deviation of FIG. 3C. That is, the voltage diagnosing unit 132 may be based on the first time window for calculation of the first moving average and the second time window for calculation of the second moving average.

The voltage diagnosing unit 132 may calculate the filter diagnosis value of each battery cell 151, 153, or 155 by using the calculated moving average diagnosis value in the above-described manner and diagnose voltage abnormality based on the calculated filter diagnosis value.

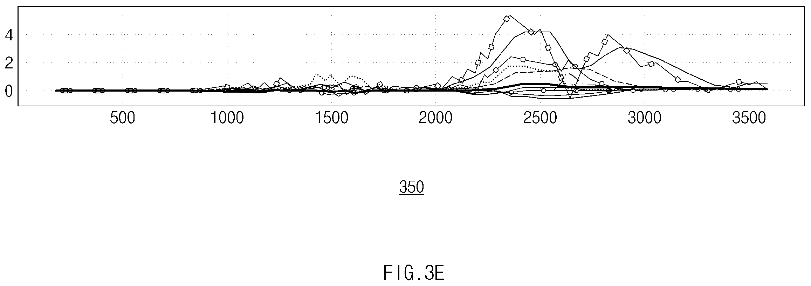

Referring to FIG. 3E, a graph 350 is illustrated which shows the long-short term voltage moving average difference of the plurality of battery cells (e.g., 151, 153, and 155), calculated by the voltage diagnosing unit 132 through the processes (i) and (ii). In the graph 350, a horizontal axis may indicate a time and a vertical axis may indicate a moving average difference.

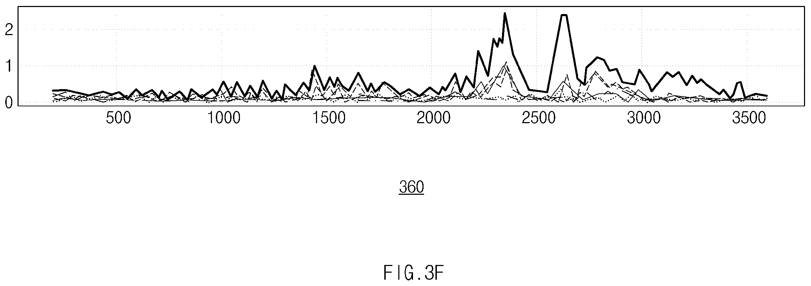

Referring to FIG. 3F, a graph 360 is illustrated which shows the moving average diagnosis value of the plurality of battery cells (e.g., 151, 153, and 155), calculated through the process (iii). In the graph 360, a horizontal axis may indicate a time and a vertical axis may indicate a moving average diagnosis value.

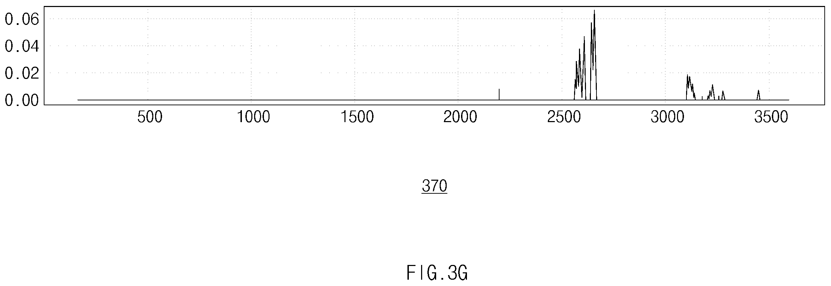

Referring to FIG. 3G, a graph 370 is illustrated which shows the filter diagnosis values of the plurality of battery cells (e.g., 151, 153, and 155) calculated by the voltage diagnosing unit 132 based on the moving average diagnosis value of FIG. 3F. In the graph 370, a horizontal axis may indicate a time and a vertical axis may indicate a filter diagnosis value.

According to an embodiment, the voltage diagnosing unit 132 may recursively repeat the processes (i) to (iii) at least once. That is, the voltage diagnosing unit 132 may replace the voltage time-series data of FIG. 2 with the moving average diagnosis value of FIG. 3F.

Once the foregoing recursive operation process is repeated, voltage abnormality diagnosis of the battery cell may be performed more precisely. Referring to FIG. 3D, a positive profile pattern is seen from two time periods in time-series data of a filter diagnosis value of a battery cell having voltage abnormality. However, referring to FIG. 3G, a positive profile pattern is seen from more time periods than in FIG. 3D in the time-series data of the filter diagnosis value of the battery cell having voltage abnormality. Thus, upon repetition of the recursive operation process, a point in time when voltage abnormality of the battery cell occurs may be more accurately detected.

Capacity Abnormality Diagnosis

According to an embodiment, the capacity diagnosing unit 133 may calculate SOH of the plurality of battery cells 151, 153, and 155 based on the time-series data obtained by the obtaining unit 131. Herein, SOH may indicate a life-related parameter of the battery cell 151, 153, and/or 155 and may include at least one of SOHc indicating SOH for a capacity of a battery or SOHr indicating SOH for resistance growth of the battery. Hereinbelow, a description will be made of an embodiment in which the capacity diagnosing unit 133 calculates SOHc. However, this is merely an embodiment, and the capacity diagnosing unit 133 may calculate various SOH such as SOHc, SOHr, final SOH calculated based thereon, etc.

According to an embodiment, the capacity diagnosing unit 133 may calculate an SOC difference before and after charging periods of the plurality of battery cells 151, 153, and 155 based on the time-series data.

For example, the capacity diagnosing unit 133 may calculate the SOC difference by using an SOC value at the first point in time before the charging period and an SOC value at the second point in time after the charging period, based on SOC data included in the time-series data.

In another example, the capacity diagnosing unit 133 may calculate open circuit voltages (OCV) of the plurality of battery cells 151, 153, and 155 based on at least one of time-series voltage data or time-series current data included in the time-series data, convert the calculated OCV into SOC by using an SOC-OCV table stored in advance in the memory 130, and calculate the SOC difference.

According to an embodiment, the capacity diagnosing unit 133 may calculate a current integration value of the plurality of battery cells 151, 153, and 155 in the charging period based on the time-series data. For example, the capacity diagnosing unit 133 may calculate a current value in the charging period, included in the time-series data, and the current integration value in the charging period based on a time length of the charging period. Herein, the unit of the current integration value may be an 'Ampere hour (Ah)'.

According to another embodiment, the capacity diagnosing unit 133 may calculate the current integration value in the charging period when the calculated SOC difference is greater than or equal to (exceeds) a designated value. For example, the capacity diagnosing unit 133 may not calculate the current integration value of the battery cell 151, 153, or 155 in the current period when an SOC difference of the battery cell 151, 153, or 155 calculated in the current period is less than (or less than or equal to) the designated value. In this case, as the current integration value of the battery cell 151, 153, or 155 is not calculated, the capacity diagnosing unit 133 may not calculate the SOHc of the battery cell 151, 153, or 155. In another example, the capacity diagnosing unit 133 may calculate the current integration value of the battery cell 151, 153, or 155 in the current period when the SOC difference of the battery cell 151, 153, or 155 calculated in the current period is greater than or equal to (or exceeds) the designated value. In this case, the capacity diagnosing unit 133 may calculate the SOHc of the battery cell 151, 153, or 155 by using the current integration value of the battery cell 151, 153, or 155.

According to an embodiment, the capacity diagnosing unit 133 may calculate the $SOH_c$ of the battery cell 151, 153, and/or 155 based on an SOC difference, a current integration value, and an initial capacity of the battery cell 151, 153, and/or 155. Herein, a unit of the initial capacity of the battery cell 151, 153, and/or 155 may be the same as a unit of the current integration value, 'Ah'.

For example, the capacity diagnosing unit 133 may calculate the $SOH_c$ of the battery cell 151, 153, and/or 155 based on Equation 3.

[Equation 3]

$$SOH_c = 100*(I\Delta T)/(C*\Delta SOC/100)$$

In Equation 3, $I\Delta T$ indicates the current integration value of the battery cell 151, 153, and/or 155, $\Delta SOC$ indicates the SOC difference of the battery cell 151, 153, and/or 155, and C indicates the initial value of the battery cell 151, 153, and/or 155.

Referring to FIG. 4A, a graph 410 is illustrated which shows $SOH_c$ of the plurality of battery cells (e.g., 151, 153, and 155) calculated by the capacity diagnosing unit 133. In the graph 410, a horizontal axis may indicate a time and a vertical axis may indicate $SOH_c$.

According to an embodiment, the capacity diagnosing unit 133 may calculate SOHc of diagnosis target battery cells every unit time. The battery diagnosis apparatus 101 may cumulatively store SOHc, calculated by the capacity diagnosing unit 133, in the memory 130 for a designated time to manage SOHc data as indicated by the graph 410.

According to an embodiment, the capacity diagnosing unit 133 may calculate an SOH deviation based on SOH (e.g., the calculated $SOH_c$) of each battery cell 151, 153, or 155. For example, the SOH deviation may a deviation between an SOH median value of the plurality of battery cells 151, 153, and 155 and SOH of each battery cell 151, 153, or 155, a deviation between an SOH average of the plurality of battery cells 151, 153, and 155 and SOH of each battery cell 151, 153, or 155, or a deviation between an average of SOH moving averages of the plurality of battery cells 151, 153, and 155 and an SOH moving average of each battery cell 151, 153, or 155.

According to an embodiment, the capacity diagnosing unit 133 may calculate an SOH moving average of each battery cell 151, 153, or 155 every unit time based on a third time window. Herein, a time length of the third time window may be an integer multiple of a unit time, and an end point of the third time window may be the present point in time and a start point of the third time window may be a point in time ahead of the present point in time by a predetermined time length. The moving average may mean any one of a simple moving average, a weighted moving average, or an exponential moving average.

Hereinbelow, a description will be made of an embodiment in which the capacity diagnosing unit 133 calculates an SOH exponential moving average. However, this is merely an example and the capacity diagnosing unit 133 may calculate various moving averages such as an SOH simple moving average, an SOH weighted moving average, the SOH exponential moving average, etc.

According to an embodiment, the capacity diagnosing unit 133 may input SOH of each battery cell 151, 153, or 155 into Equation 4 to calculate the SOH exponential moving average of the present point in time.

[Equation 4]

$$EMA_t = \alpha*SOH + (1-\alpha)*EMA_{t-1}$$

In Equation 4, EMAt indicates the SOH exponential moving average of the battery cell 151, 153, or 155 at the present point in time, $\alpha$ indicates a weight value, SOH indicates SOH of the battery cell 151, 153, or 155 at the present point in time, and $EMA_{t-1}$ indicates an SOH exponential moving average of the battery cell 151, 153, or 155 at a previous point in time. Herein, the weight value may be set variously according to specifications of the plurality of battery cells 151, 153, and 155. For example, the weight value may be set to, but not limited to, 0.05.

Referring to FIG. 4B, a graph 420 is illustrated which shows an SOH exponential moving average of the plurality of battery cells (e.g., 151, 153, and 155), calculated by the capacity diagnosing unit 133. In the graph 420, a horizontal axis may indicate a time and a vertical axis may indicate an SOH exponential moving average.

According to an embodiment, the capacity diagnosing unit 133 may calculate an SOH moving average of diagnosis target battery cells every unit time. The battery diagnosis apparatus 101 may cumulatively store the SOH moving average, calculated by the capacity diagnosing unit 133, in the memory 130 for a designated time to manage moving average data as indicated by the graph 420. According to an embodiment, the capacity diagnosing unit 133 may obtain moving average data of diagnosis target battery cells by applying the SOH data (e.g., the graph 410 of FIG. 4) stored in the memory 130 to a moving average filter.

According to an embodiment, the capacity diagnosing unit 133 may calculate an SOH deviation corresponding to a deviation between an average of a plurality of SOH moving averages of the plurality of battery cells 151, 153, and 155 and an SOH moving average of each battery cell 151, 153, or 155, for each battery cell 151, 153, or 155, every unit time.

According to an embodiment, the capacity diagnosing unit 133 may diagnose capacity abnormality of each battery cell 151, 153, or 155 based on the SOH deviation. For example, the capacity diagnosing unit 133 may diagnose whether there is a defect due to capacity reduction of each battery cell 151, 153, or 155.

According to an embodiment, the capacity diagnosing unit 133 may compare an SOH deviation with a preset threshold value to diagnose capacity abnormality of each battery cell 151, 153, or 155. For example, the capacity diagnosing unit 133 may diagnose, as a capacity abnormality battery cell, a battery cell having an SOH deviation that exceeds (or is greater than or equal to) the threshold value.

For example, the capacity diagnosing unit 133 may integrate a time period in which an SOH deviation is greater than (or greater than or equal to) the threshold value for each battery cell 151, 153, or 155, and diagnose, as a battery cell having capacity abnormality, a battery cell for which the condition that the integration time is greater than (or greater than or equal to) the preset reference time is satisfied. The battery diagnosis apparatus 101 may integrate a time period in which the condition that the SOH deviation is greater than (or greater than or equal to) the threshold value is continuously satisfied. When there are a plurality of time periods, the battery diagnosis apparatus 101 may independently calculate the integration time every time period.

In another example, the battery diagnosis apparatus 101 may integrate the number of pieces of data included in the time period in which an SOH deviation is greater than (or greater than or equal to) the threshold value from time-series data of the SOH deviation, and diagnose, as a battery cell having capacity abnormality, a battery cell for which the condition that the data integration value is greater than (or greater than or equal to) the preset reference count is satisfied. The battery diagnosis apparatus 101 may integrate the number of pieces of data included in the time period in which the condition that the SOH deviation is greater than (or greater than or equal to) the threshold value is continuously satisfied. When there are a plurality of time periods, the battery diagnosis apparatus 101 may independently integrate the number of pieces of data of each time period.

According to an embodiment, the detecting unit 134 may detect an abnormal battery cell based on at least one of a voltage abnormality diagnosis result of the voltage diagnosing unit 132 or a capacity abnormality diagnosis result of the capacity diagnosing unit 133.

For example, the detecting unit 134 may detect, as an abnormal battery cell, a battery cell diagnosed as having voltage abnormality by the voltage diagnosing unit 132 and having capacity abnormality by the capacity diagnosing unit 133.

In another example, the capacity diagnosing unit 133 may diagnose capacity abnormality for at least one battery cell diagnosed as having voltage abnormality by the voltage diagnosing unit 132. In this case, the detecting unit 134 may detect, as an abnormal battery cell, a battery cell diagnosed as having capacity abnormality by the capacity diagnosing unit 133. That is, in a corresponding example, the battery diagnosis apparatus 101 may diagnose voltage abnormality of each battery cell 151, 153, or 155 by primarily using the voltage diagnosing unit 132, diagnose capacity abnormality by secondarily using the capacity diagnosing unit 133 for at least one battery cell having voltage abnormality, and finally detect a battery cell having capacity abnormality as an abnormal battery cell.

According to an embodiment, the abnormality processing unit 135 may perform an abnormality processing function based on abnormality diagnosis results for the plurality of battery cells 151, 153, and 155. Herein, the abnormality processing function may include a notification function or a short-circuit function.

According to an embodiment, the abnormality processing unit 135 may transmit the abnormality diagnosis results for the plurality of battery cells 151, 153, and 155 to the user terminal 104 connected through a wired and/or wireless network.

According to an embodiment, the abnormality processing unit 135 may isolate an abnormal battery cell from the electronic device 102 based on the abnormality diagnosis results for the plurality of battery cells 151, 153, and 155. Herein, isolation may include electrical and/or mechanical isolation.

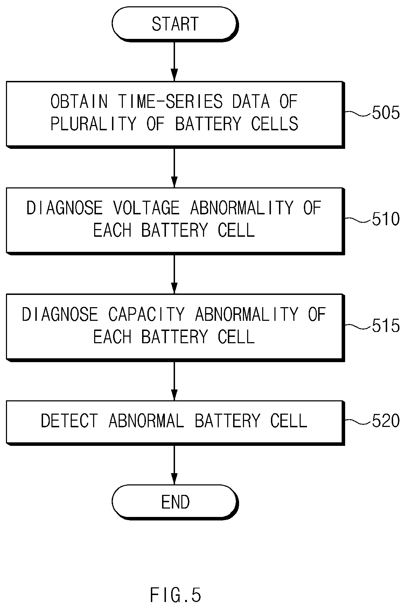

FIG. 5 is an operating flowchart of a battery diagnosis apparatus according to an embodiment. FIG. 5 will be described using the components of FIG. 1.

An embodiment shown in FIG. 5 is merely an embodiment, and an order of operations according to various embodiments of the present disclosure may be different from that shown in FIG. 5, some operations shown in FIG. 5 may be omitted, or an order of the operations may be changed or operations may be merged.

Referring to FIG. 5, in operation 505, the battery diagnosis apparatus 101 may obtain time-series data related to states of the plurality of battery cells 151, 153, and 155. According to an embodiment, the battery diagnosis apparatus 101 may obtain the time-series data by using the communication circuit 110 and/or the sensor 120.

In operation 510, the battery diagnosis apparatus 101 may diagnose voltage abnormality of each battery cell 151, 153, or 155, based on the time-series data obtained in operation 505. More specifically, the battery diagnosis apparatus 101 may diagnose voltage abnormality of each battery cell 151, 153, or 155, based on voltage time-series data included in the time-series data.

According to an embodiment, the battery diagnosis apparatus 101 may calculate a long-short term voltage moving average difference of each battery cell 151, 153, or 155 based on the time-series data and diagnose voltage abnormality of each battery cell 151, 153, or 155 based on the calculated long-short term voltage moving average difference.

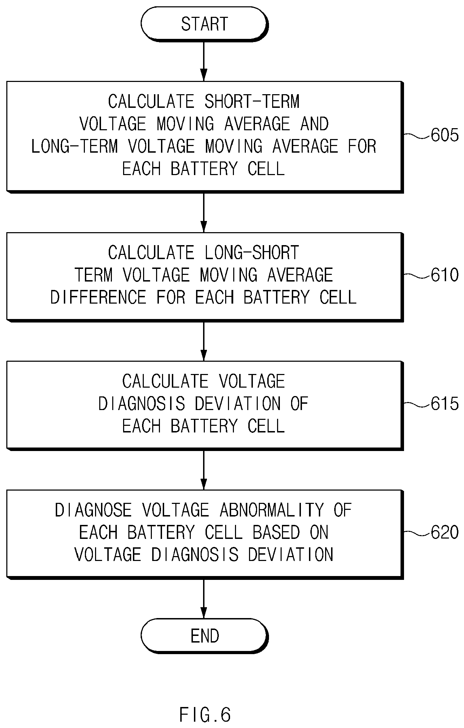

Operation 510, performed by the battery diagnosis apparatus 101, of diagnosing voltage abnormality of each battery cell 151, 153, or 155 will be descried in detail with reference to FIGS. 6 to 8 described below.

In operation 515, the battery diagnosis apparatus 101 may diagnose capacity abnormality of each battery cell 151, 153, or 155, based on the time-series data obtained in operation 505.

According to an embodiment, the battery diagnosis apparatus 101 may calculate an SOH difference of each battery cell 151, 153, or 155 based on the time-series data and diagnose capacity abnormality of each battery cell 151, 153, or 155 based on the calculated SOH deviation.

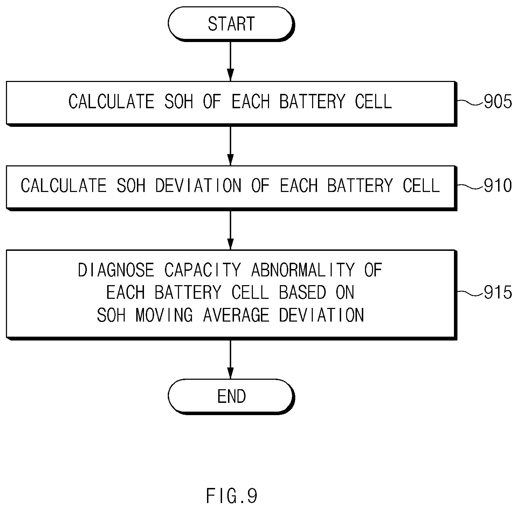

Operation 515, performed by the battery diagnosis apparatus 101, of diagnosing capacity abnormality of each battery cell 151, 153, or 155 will be descried in detail with reference to FIG. 9 described below.

In operation 520, the battery diagnosis apparatus 101 may detect an abnormal battery cell among the plurality of battery cells 151, 153, and 155. According to an embodiment, the battery diagnosis apparatus 101 may detect an abnormal battery cell based on at least one of a voltage abnormality diagnosis result of operation 510 or a capacity abnormality diagnosis result of operation 515.

For example, the battery diagnosis apparatus 101 may detect, as an abnormal battery cell, a battery cell diagnosed as having voltage abnormality in operation 510 and diagnosed as having capacity abnormality in operation 515.

Hereinbelow, an operation, performed by the battery diagnosis apparatus 101, of diagnosing voltage abnormality of each battery cell 151, 153, or 155 will be descried with reference to FIGS. 6 to 8.

FIG. 6 is an operation flowchart of a battery diagnosis apparatus according to an embodiment. FIG. 6 will be described using the components of FIG. 1.

An embodiment shown in FIG. 6 is merely an embodiment, and an order of operations according to various embodiments of the present disclosure may be different from that shown in FIG. 6, some operations shown in FIG. 6 may be omitted, or an order of the operations may be changed or operations may be merged.

Referring to FIG. 6, in operation 605, the battery diagnosis apparatus 101 may calculate a long-short term voltage moving average difference of each battery cell 151, 153, or 155 based on the time-series data obtained in operation 505 of FIG. 5.

According to an embodiment, the battery diagnosis apparatus 101 may calculate a short-term voltage moving average of each battery cell 151, 153, or 155 every unit time based on the first time window. The battery diagnosis apparatus 101 may calculate a long-term voltage moving average of each battery cell 151, 153, or 155 every unit time based on the second time window.

For example, an input factor in voltage moving average calculation may be a voltage value of each battery cell 151, 153, or 155 in a specific time window (e.g., the first time window or the second time window). In this case, the calculated voltage moving average may indicate a long-short term moving average for a voltage value of each battery cell 151, 153, or 155.

In another example, the input factor in voltage moving average calculation may be a deviation between a reference voltage for the plurality of battery cells 151, 153, and 155 and a voltage of each battery cell 151, 153, or 155 in a specific time window (e.g., the first time window or the second time window). Herein, the reference voltage may be determined from the plurality of battery cells 151, 153, and 155, and may be determined as an average value or a median value of voltage values of the plurality of battery cells 151, 153, and 155. In this case, the calculated voltage moving average may indicate a long-short term moving average for a voltage deviation of each battery cell 151, 153, or 155.

In operation 610, the battery diagnosis apparatus 101 may calculate a long-short term voltage moving average difference corresponding to a difference between the short-term voltage moving average and the long-term voltage moving average for each battery cell 151, 153, or 155 every unit time. Herein, the long-short term voltage moving average difference may be a value obtained by subtracting the smaller one between the short-term voltage moving average and the long-term voltage moving average, calculated in operation 605, from the larger one.

According to an embodiment, the battery diagnosis apparatus 101 may diagnose voltage abnormality of each battery cell 151, 153, or 155 based on the long-short term voltage moving average difference of each battery cell 151, 153, or 155.

In operation 615, the battery diagnosis apparatus 101 may calculate a voltage diagnosis deviation of each battery cell 151, 153, or 155 every unit time based on the long-short term voltage moving average difference calculated in operation 610.

According to an embodiment, the battery diagnosis apparatus 101 may calculate a voltage diagnosis deviation corresponding to a deviation between an average of long-short term voltage moving average differences of the plurality of battery cells 151, 153, and 155 and the long-short term voltage moving average difference of each battery cell 151, 153, or 155, for each battery cell 151, 153, or 155.

According to an embodiment, the battery diagnosis apparatus 101 may calculate a normalized value of a long-short term voltage moving average difference as a normalized voltage diagnosis deviation every unit time for each battery cell 151, 153, or 155.

For example, the battery diagnosis apparatus 101 may normalize the long-short term voltage moving average difference of each battery cell 151, 153, or 155 by using the average of the long-short term voltage moving average differences of the plurality of battery cells 151, 153, and 155. For example, the battery diagnosis apparatus 101 may normalize the long-short term voltage moving average difference by performing a division operation (e.g., DSL/Dav in which DSL indicates the long-short term voltage moving average difference and Dav indicates the average) on the long-short term voltage moving average difference of each battery cell 151, 153, or 155 with the average.

In another example, the battery diagnosis apparatus 101 may perform normalization through a log operation (e.g., Log(DSL) in which DSL indicates a long-short term voltage moving average difference) on the long-short term voltage moving average difference of each battery cell 151, 153, or 155.

In operation 620, the battery diagnosis apparatus 101 may diagnose voltage abnormality of each battery cell 151, 153, or 155, based on the voltage diagnosis deviation obtained in operation 615. For example, the battery diagnosis apparatus 101 may diagnose, as a battery cell having voltage abnormality, a battery cell having the calculated voltage diagnosis deviation exceeding a preset threshold value (e.g., 0.015).

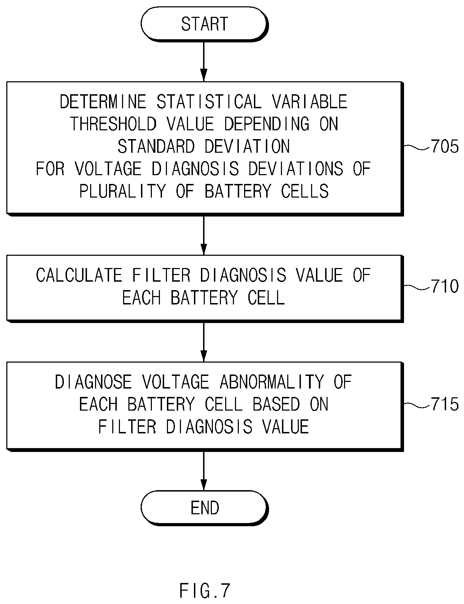

According to an embodiment, the battery diagnosis apparatus 101 may diagnose voltage abnormality of each battery cell 151, 153, or 155 by comparing the voltage diagnosis deviation (or the normalized voltage diagnosis deviation), calculated in operation 615, with a statistical variable threshold value. An operation, performed by the battery diagnosis apparatus 101, of diagnosing voltage abnormality by comparing the voltage diagnosis deviation with the statistical variable threshold value will be described in detail with reference to FIG. 7 described below.

FIG. 7 is an operation flowchart of a battery diagnosis apparatus according to an embodiment. FIG. 7 will be described using the components of FIG. 1.

An embodiment shown in FIG. 7 is merely an embodiment, and an order of operations according to various embodiments of the present disclosure may be different from that shown in FIG. 7, some operations shown in FIG. 7 may be omitted, or an order of the operations may be changed or operations may be merged.

Referring to FIG. 7, in operation 705, the battery diagnosis apparatus 101 may determine the statistical variable threshold value depending on a standard deviation for the voltage diagnosis deviations (or the normalized voltage diagnosis deviations) of the plurality of battery cells 151, 153, and 155 every unit time. For example, the voltage diagnosing unit 132 may determine the statistical variable threshold value based on Equation 1.

In operation 710, the battery diagnosis apparatus 101 may calculate a filter diagnosis value by filtering the voltage diagnosis deviation (or the normalized voltage diagnosis deviation) of each battery cell 151, 153, or 155 based on the statistical variable threshold value. For example, the battery diagnosis apparatus 101 may calculate one of two values as the filter diagnosis value, based on Equation 2.

In operation 715, the battery diagnosis apparatus 101 may diagnose voltage abnormality of each battery cell 151, 153, or 155, based on the filter diagnosis value calculated in operation 710.

For example, the battery diagnosis apparatus 101 may integrate a time period in which the filter diagnosis value is greater than (or greater than or equal to) a diagnosis threshold value (e.g., 0) for each battery cell 151, 153, or 155, and diagnose, as a battery cell having voltage abnormality, a battery cell for which a condition that an integration time is greater than (or greater than or equal to) a preset reference time is satisfied. The battery diagnosis apparatus 101 may integrate a time period in which a condition that the filter diagnosis value is greater than (or greater than or equal to) the diagnosis threshold value is continuously satisfied. When there are a plurality of time periods, the battery diagnosis apparatus 101 may independently calculate the integration time every time period.

In another example, the battery diagnosis apparatus 101 may integrate the number of pieces of data included in the time period in which the filter diagnosis value is greater than (or greater than or equal to) the diagnosis threshold value (e.g., 0) from time-series data of the filter diagnosis value, and diagnose, as a battery cell having voltage abnormality, a battery cell for which a condition that a data integration value is greater than (or greater than or equal to) a preset reference count is satisfied. The battery diagnosis apparatus 101 may integrate the number of pieces of data included in the time period in which the condition that the filter diagnosis value is greater than (or greater than or equal to) the diagnosis threshold value is continuously satisfied. When there are a plurality of time periods, the battery diagnosis apparatus 101 may independently integrate the number of pieces of data of each time period.

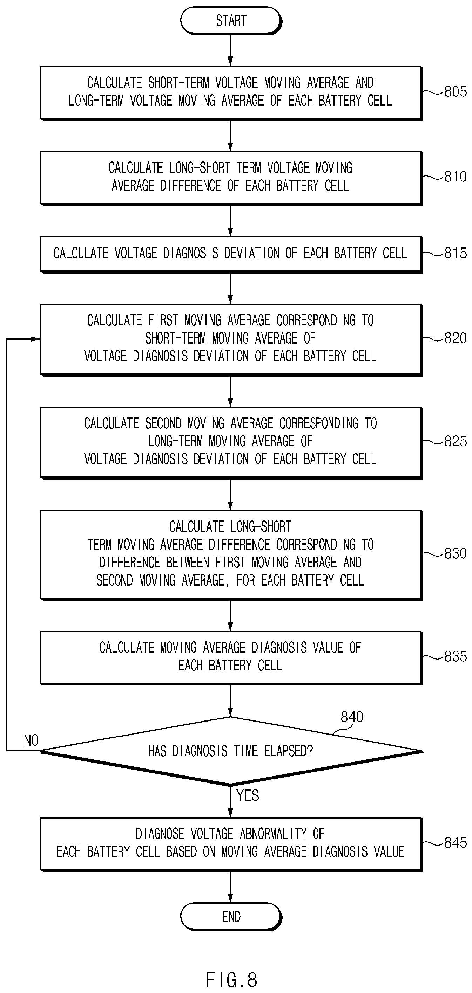

FIG. 8 is an operation flowchart of a battery diagnosis apparatus according to an embodiment. FIG. 8 will be described using the components of FIG. 1.

An embodiment shown in FIG. 8 is merely an embodiment, and an order of operations according to various embodiments of the present disclosure may be different from that shown in FIG. 8, some operations shown in FIG. 8 may be omitted, or an order of the operations may be changed or operations may be merged.

Operations 805 to 815 of FIG. 8 are the same as operations 605 to 615 of FIG. 6 and thus will not be described.

Referring to FIG. 8, in operation 820, the battery diagnosis apparatus 101 may calculate a first moving average corresponding to a short-term moving average of the voltage diagnosis deviation (or the normalized voltage diagnosis deviation) calculated in operation 815. The battery diagnosis apparatus 101 may be based on the first time window in calculation of the first moving average.

In operation 825, the battery diagnosis apparatus 101 may calculate a second moving average corresponding to a long-term moving average of the voltage diagnosis deviation (or the normalized voltage diagnosis deviation) calculated in operation 815. The battery diagnosis apparatus 101 may be based on the second time window in calculation of the second moving average.

In operation 830, the battery diagnosis apparatus 101 may calculate a long-short term moving average difference corresponding to a difference between the first moving average calculated in operation 820 and the second moving average calculated in operation 825, for each battery cell 151, 153, or 155.

In operation 835, the battery diagnosis apparatus 101 may calculate a moving average diagnosis value of each battery cell 151, 153, or 155. According to an embodiment, the battery diagnosis apparatus 101 may calculate a normalized value of the long-short term voltage moving average difference, calculated in operation 830, as a moving average diagnosis value for each battery cell 151, 153, or 155.

In operation 804, the battery diagnosis apparatus 101 may determine whether a diagnosis time has elapsed. The diagnosis time may be preset.

When it is determined in operation 840 that the diagnosis time has not elapsed ('NO'), the battery diagnosis apparatus 101 may recursively repeat operations 820 to 835.

When it is determined in operation 840 that the diagnosis time has elapsed ('YES'), the battery diagnosis apparatus 101 may diagnose voltage abnormality of each battery cell 151, 153, or 155 based on the moving average diagnosis value calculated in operation 835. For example, the battery diagnosis apparatus 101 may diagnose voltage abnormality of each battery cell 151, 153, or 155 by comparing the moving average diagnosis value with a preset threshold value. In another example, the battery diagnosis apparatus 101 may calculate the filter diagnosis value of each battery cell 151, 153, or 155 according to a method described with reference to FIG. 7 and diagnose voltage abnormality based on the calculated filter diagnosis value.

Hereinbelow, an operation, performed by the battery diagnosis apparatus 101, of diagnosing capacity abnormality of each battery cell 151, 153, or 155 will be descried with reference to FIG. 9.

FIG. 9 is an operation flowchart of a battery diagnosis apparatus according to an embodiment. FIG. 9 will be described using the components of FIG. 1.

An embodiment shown in FIG. 9 is merely an embodiment, and an order of operations according to various embodiments of the present disclosure may be different from that shown in FIG. 9, some operations shown in FIG. 9 may be omitted, or an order of the operations may be changed or operations may be merged.

Referring to FIG. 9, in operation 905, the battery diagnosis apparatus 101 may calculate SOH of each battery cell 151, 153, or 155 every unit time based on the time-series data obtained in operation 505 of FIG. 5. Herein, SOH may indicate a life-related parameter of the battery cell 151, 153, and/or 155 and may include at least one of SOHc indicating SOH for a capacity of a battery or SOHr indicating SOH for resistance growth of the battery. Hereinbelow, a description will be made of an embodiment in which the battery diagnosis apparatus 101 calculates SOHc. However, this is merely an embodiment, and the battery diagnosis apparatus 101 may calculate various SOH such as SOHc, SOHr, final SOH calculated based thereon, etc.

According to an embodiment, the battery diagnosis apparatus 101 may calculate an SOC difference before and after charging periods of the plurality of battery cells 151, 153, and 155 based on the time-series data.

For example, the battery diagnosis apparatus 101 may calculate the SOC difference by using an SOC value at the first point in time before the charging period and an SOC value at the second point in time after the charging period, based on SOC data included in the time-series data.

In another example, the battery diagnosis apparatus 101 may calculate open circuit voltages (OCV) of the plurality of battery cells 151, 153, and 155 based on at least one of time-series voltage data or time-series current data included in the time-series data, convert the calculated OCV into SOC by using an SOC-OCV table stored in advance in the memory 130, and calculate the SOC difference.

According to an embodiment, the battery diagnosis apparatus 101 may calculate a current integration value of the plurality of battery cells 151, 153, and 155 in the charging period based on the time-series data. For example, the battery diagnosis apparatus 101 may calculate a current value in the charging period, included in the time-series data, and the current integration value in the charging period based on a time length of the charging period. Herein, the unit of the current integration value may be an 'Ampere hour (Ah)'.

According to another embodiment, the battery diagnosis apparatus 101 may calculate the current integration value in the charging period when the calculated SOC difference is greater than or equal to (exceeds) a designated value. For example, the battery diagnosis apparatus 101 may not calculate the current integration value of the battery cell 151, 153, or 155 in the current period when an SOC difference of the battery cell 151, 153, or 155 calculated in the current period is less than (or less than or equal to) the designated value. In this case, as the current integration value of the battery cell 151, 153, or 155 is not calculated, the battery diagnosis apparatus 101 may not calculate the SOHc of the battery cell 151, 153, or 155. In another example, the battery diagnosis apparatus 101 may calculate the current integration value of the battery cell 151, 153, or 155 in the current period when the SOC difference of the battery cell 151, 153, or 155 calculated in the current period is greater than or equal to (or exceeds) the designated value. In this case, the battery diagnosis apparatus 101 may calculate the SOHc of the battery cell 151, 153, or 155 by using the current integration value of the battery cell 151, 153, or 155.

According to an embodiment, the battery diagnosis apparatus 101 may calculate the SOHc of the battery cell 151, 153, and/or 155 based on an SOC difference, a current integration value, and an initial capacity of the battery cell 151, 153, and/or 155. Herein, a unit of the initial capacity of the battery cell 151, 153, and/or 155 may be the same as a unit of the current integration value, 'Ah'.

For example, the battery diagnosis apparatus 101 may calculate the SOHc of the battery cell 151, 153, and/or 155 based on Equation 3.

In operation 910, the battery diagnosis apparatus 101 may calculate an SOH deviation of each battery cell 151, 153, or 155. For example, the SOH deviation may a deviation between an SOH median value of the plurality of battery cells 151, 153, and 155 and SOH of each battery cell 151, 153, or 155, a deviation between an SOH average of the plurality of battery cells 151, 153, and 155 and SOH of each battery cell 151, 153, or 155, or a deviation between an average of SOH moving averages of the plurality of battery cells 151, 153, and 155 and an SOH moving average of each battery cell 151, 153, or 155.

According to an embodiment, the battery diagnosis apparatus 101 may calculate an SOH moving average of each battery cell 151, 153, or 155 every unit time based on the third time window. Herein, a time length of the third time window may be an integer multiple of a unit time, and an end point of the third time window may be the present point in time and a start point of the third time window may be a point in time ahead of the present point in time by a predetermined time length. The moving average may mean any one of a simple moving average, a weighted moving average, or an exponential moving average.

Hereinbelow, a description will be made of an embodiment in which the battery diagnosis apparatus 101 calculates an SOH exponential moving average. However, this is merely an example and the battery diagnosis apparatus 101 may calculate various moving averages such as an SOH simple moving average, an SOH weighted moving average, the SOH exponential moving average, etc.

According to an embodiment, the battery diagnosis apparatus 101 may input SOH of each battery cell 151, 153, or 155 into Equation 4 to calculate the SOH exponential moving average of the present point in time.

According to an embodiment, the battery diagnosis apparatus 101 may calculate an SOH deviation corresponding to a deviation between an average of a plurality of SOH moving averages of the plurality of battery cells 151, 153, and 155 and an SOH moving average of each battery cell 151, 153, or 155, for each battery cell 151, 153, or 155.

In operation 915, the battery diagnosis apparatus 101 may diagnose capacity abnormality of each battery cell 151, 153, or 155, based on the SOH deviation. For example, the battery diagnosis apparatus 101 may diagnose whether there is a defect due to capacity reduction of each battery cell 151, 153, or 155.

According to an embodiment, the battery diagnosis apparatus 101 may compare an SOH deviation with a preset threshold value to diagnose capacity abnormality of each battery cell 151, 153, or 155. For example, the battery diagnosis apparatus 101 may diagnose, as a capacity abnormality battery cell, a battery cell having an SOH deviation that exceeds (or is greater than or equal to) the threshold value.

For example, the battery diagnosis apparatus 101 may integrate a time period in which an SOH deviation is greater than (or greater than or equal to) the threshold value for each battery cell 151, 153, or 155, and diagnose, as a battery cell having capacity abnormality, a battery cell for which the condition that the integration time is greater than (or greater than or equal to) the preset reference time is satisfied. The battery diagnosis apparatus 101 may integrate a time period in which the condition that the SOH deviation is greater than (or greater than or equal to) the threshold value is continuously satisfied. When there are a plurality of time periods, the battery diagnosis apparatus 101 may independently calculate the integration time every time period.

In another example, the battery diagnosis apparatus 101 may integrate the number of pieces of data included in the time period in which an SOH deviation is greater than (or greater than or equal to) the threshold value (e.g., 0) from time-series data of the SOH deviation, and diagnose, as a battery cell having capacity abnormality, a battery cell for which the condition that the data integration value is greater than (or greater than or equal to) the preset reference count is satisfied. The battery diagnosis apparatus 101 may integrate the number of pieces of data included in the time period in which the condition that the SOH deviation is greater than (or greater than or equal to) the threshold value is continuously satisfied. When there are a plurality of time periods, the battery diagnosis apparatus 101 may independently integrate the number of pieces of data of each time period.

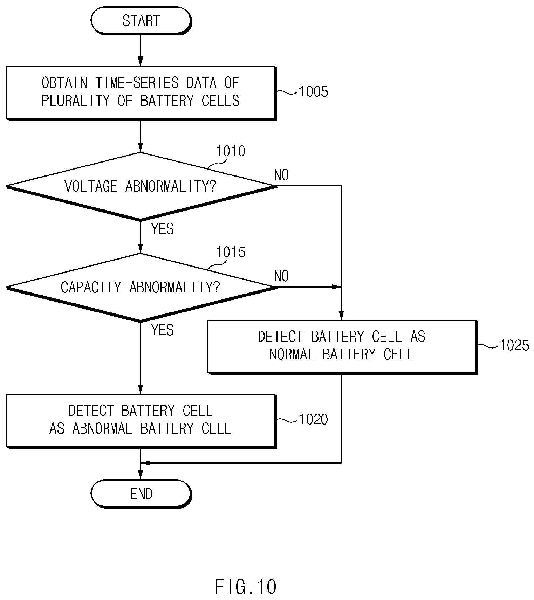

FIG. 10 is an operation flowchart of a battery diagnosis apparatus according to an embodiment. FIG. 10 will be described using the components of FIG. 1.

An embodiment shown in FIG. 10 is merely an embodiment, and an order of operations according to various embodiments of the present disclosure may be different from that shown in FIG. 10, some operations shown in FIG. 10 may be omitted, or an order of the operations may be changed or operations may be merged.

Operation 1005 of FIG. 10 is the same as operation 505 of FIG. 5 and thus will not be described.

Referring to FIG. 10, in operation 1010, the battery diagnosis apparatus 101 may diagnose whether each battery cell 151, 153, or 155 has voltage abnormality. A voltage abnormality diagnosis operation of operation 1010 may mean operation 510 of FIG. 5 and operations of FIGS. 6 to 8 described above.

When it is diagnosed in operation 1010 that the battery cell 151, 153, or 155 has voltage abnormality, the battery diagnosis apparatus 101 may diagnose whether the battery cell 151, 153, or 155 has capacity abnormality in operation 1015. A capacity abnormality diagnosis operation of operation 1015 may mean operation 510 of FIG. 5 and operations of FIG. 9 described above.

When it is diagnosed in operation 1015 that the battery cell 151, 153, or 155 has capacity abnormality, the battery diagnosis apparatus 101 may detect the battery cell 151, 153, or 155 as an abnormal battery cell in operation 1020.

When it is diagnosed in operation 1010 that the battery cell 151, 153, or 155 does not have voltage abnormality or in operation 1015 that the battery cell 151, 153, or 155 does not have capacity abnormality, the battery diagnosis apparatus 101 may detect the corresponding battery cell 151, 153, or 155 as a normal battery cell in operation 1025.

According to an embodiment, the battery diagnosis apparatus 101 may perform an abnormality processing function based on abnormality diagnosis results for the plurality of battery cells 151, 153, and 155. Herein, the abnormality processing function may include a notification function or a short-circuit function.

According to an embodiment, the battery diagnosis apparatus 101 may transmit the abnormality diagnosis results for the plurality of battery cells 151, 153, and 155 to the user terminal 104 connected through a wired and/or wireless network.

According to an embodiment, the battery diagnosis apparatus 101 may isolate an abnormal battery cell from the electronic device 102 based on the abnormality diagnosis results for the plurality of battery cells 151, 153, and 155. Herein, isolation may include electrical and/or mechanical isolation.

Terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in this document.

**Claims**

1. A battery diagnosis apparatus comprising:

    an obtaining unit configured to obtain time-series data related to states of a plurality of battery cells included in a battery module;

a voltage diagnosing unit configured to calculate a long-short term voltage moving average difference of each battery cell based on the time-series data and diagnose voltage abnormality of each battery cell based on the long-short term voltage moving average difference;

a capacity diagnosing unit configured to calculate a state of health (SOH) deviation of each battery cell based on the time-series data and diagnose capacity abnormality of each battery cell based on the SOH deviation; and

a detecting unit configured to detect an abnormal battery cell based on a diagnosis result of at least one of the voltage diagnosing unit or the capacity diagnosing unit.

2. The battery diagnosis apparatus of claim 1, wherein the voltage diagnosing unit is further configured to:

calculate a short-term voltage moving average of each battery cell based on a first time window;

calculate a long-term voltage moving average of each battery cell based on a second time window having a longer time length than the first time window; and

calculate the long-short term voltage moving average difference corresponding to a difference between the short-term voltage moving average and the long-term voltage moving average, for each battery cell.

3. The battery diagnosis apparatus of claim 1, wherein the voltage diagnosing unit is further configured to:

calculate a voltage diagnosis deviation corresponding to a deviation between an average of long-short term voltage moving average differences of the plurality of battery cells and the long-short term voltage moving average difference of each battery cell, for each battery cell; and

diagnose voltage abnormality of each battery cell based on the voltage diagnosis deviation.

4. The battery diagnosis apparatus of claim 3, wherein the voltage diagnosing unit is further configured to:

determine a statistical variable threshold value depending on a standard deviation for voltage diagnosis deviations of the plurality of battery cells;

calculate a filter diagnosis value by filtering the voltage diagnosis deviation based on the statistical variable threshold value, for each battery cell; and

diagnose voltage abnormality of each battery cell based on the filter diagnosis value.

5. The battery diagnosis apparatus of claim 1, wherein the voltage diagnosing unit is further configured to:

calculate a normalized value of the long-short term voltage moving average difference as a normalized voltage diagnosis deviation, for each battery cell; and

diagnose voltage abnormality of each battery cell based on the normalized voltage diagnosis deviation.

6. The battery diagnosis apparatus of claim 5, wherein the voltage diagnosing unit is further configured to:

determine a statistical variable threshold value depending on a standard deviation for normalized voltage diagnosis deviations of the plurality of battery cells;

calculate a filter diagnosis value by filtering the normalized voltage diagnosis deviation based on the statistical variable threshold value, for each battery cell; and

diagnose voltage abnormality of each battery cell based on the filter diagnosis value.

7. The battery diagnosis apparatus of claim 5, wherein the voltage diagnosing unit is further configured to: calculate a moving average diagnosis value by recursively repeating processes (i) to (iii) at least once for each battery cell, the processes (i) to (iii) comprising:

(i) calculating a first moving average corresponding to a short-term moving average of a normalized voltage diagnosis deviation of each battery cell and a second moving average corresponding to a long-term moving average, (ii) calculating a long-short term moving average difference corresponding to a difference between the first moving average and the second moving average, for each battery cell, and (iii) calculating a normalized value of the long-short term moving average difference as a moving average diagnosis value, for each battery cell; and

diagnose voltage abnormality of each battery cell based on the moving average diagnosis value.

8. The battery diagnosis apparatus of claim 1, wherein the capacity diagnosing unit is further configured to:

calculate a state of health (SOH) of each battery cell based on the time-series data; and

calculate, for each battery cell, the SOH deviation corresponding to a deviation between an SOH median value or SOH average of the plurality of battery cells and an SOH of each battery cell.

9. The battery diagnosis apparatus of claim 1, wherein the capacity diagnosing unit is further configured to:

calculate a state of health (SOH) of each battery cell based on the time-series data;
calculate an SOH moving average of each battery cell based on a third time window; and
calculate, for each battery cell, the SOH deviation corresponding to a deviation between an average of SOH moving averages of the plurality of battery cells and an SOH moving average of each battery cell.

10. The battery identification apparatus of claim 1, wherein the capacity diagnosing unit is further configured to:

calculate a state of charge (SOC) difference of each battery cell before and after a charging period, based on the time-series data;
calculate a current integration value of each battery cell in the charging period, based on the time-series data;
calculate, for each battery cell, SOHc indicating SOH regarding a capacity of each battery cell, based on the SOC difference, the current integration value, and an initial capacity of each battery cell; and
calculate the SOH deviation of each battery cell, based on SOHc.

11. The battery diagnosis apparatus of claim 1, wherein the capacity diagnosing unit is further configured to diagnose capacity abnormality for at least one battery cell diagnosed as having voltage abnormality by the voltage diagnosing unit.

12. The battery diagnosis apparatus of claim 11, wherein the detecting unit is further configured to detect, as the abnormal battery cell, a battery cell diagnosed as having capacity abnormality by the capacity diagnosing unit.

13. The battery diagnosis apparatus of claim 1, wherein the detecting unit is further configured to detect, as the abnormal battery cell, a battery cell diagnosed as having voltage abnormality by the voltage diagnosing unit and having capacity abnormality by the capacity diagnosing unit.

14. A battery diagnosis method comprising:

obtaining time-series data related to states of a plurality of battery cells included in a battery module;
calculating a long-short term voltage moving average difference of each battery cell based on the time-series data and diagnosing voltage abnormality of each battery cell based on the long-short term voltage moving average difference;
calculating a state of health (SOH) deviation of each battery cell based on the time-series data and diagnosing capacity abnormality of each battery cell based on the SOH deviation; and
detecting an abnormal battery cell based on at least one of diagnosis results of at least one of the voltage diagnosing unit or the capacity diagnosing unit.

15. The battery diagnosis method of claim 13, wherein the diagnosing of capacity abnormality for each battery cell comprises diagnosing capacity abnormality for at least one battery cell diagnosed as having voltage abnormality, and
the detecting of the abnormal battery cell comprises detecting, as the abnormal battery cell, a battery cell diagnosed as having capacity abnormality.

FIG.1

200

FIG.2

310

FIG.3A

320

FIG.3B

330

FIG.3C

340

FIG.3D

350

FIG.3E

360

FIG.3F

370

FIG.3G

410

FIG.4A

420

FIG.4B

START

OBTAIN TIME-SERIES DATA OF
PLURALITY OF BATTERY CELLS — 505

DIAGNOSE VOLTAGE ABNORMALITY OF
EACH BATTERY CELL — 510

DIAGNOSE CAPACITY ABNORMALITY OF
EACH BATTERY CELL — 515

DETECT ABNORMAL BATTERY CELL — 520

END

FIG.5

START

↓

CALCULATE SHORT-TERM
VOLTAGE MOVING AVERAGE AND
LONG-TERM VOLTAGE MOVING AVERAGE FOR
EACH BATTERY CELL — 605

↓

CALCULATE LONG-SHORT
TERM VOLTAGE MOVING AVERAGE
DIFFERENCE FOR EACH BATTERY CELL — 610

↓

CALCULATE VOLTAGE
DIAGNOSIS DEVIATION OF
EACH BATTERY CELL — 615

↓

DIAGNOSE VOLTAGE ABNORMALITY OF
EACH BATTERY CELL BASED ON
VOLTAGE DIAGNOSIS DEVIATION — 620

↓

END

FIG.6

START

DETERMINE STATISTICAL VARIABLE
THRESHOLD VALUE DEPENDING ON
STANDARD DEVIATION
FOR VOLTAGE DIAGNOSIS DEVIATIONS OF
PLURALITY OF BATTERY CELLS ~705

CALCULATE FILTER DIAGNOSIS VALUE OF
EACH BATTERY CELL ~710

DIAGNOSE VOLTAGE ABNORMALITY OF
EACH BATTERY CELL BASED ON
FILTER DIAGNOSIS VALUE ~715

END

FIG.7

START

CALCULATE SHORT-TERM VOLTAGE MOVING AVERAGE AND LONG-TERM VOLTAGE MOVING AVERAGE OF EACH BATTERY CELL ~805

CALCULATE LONG-SHORT TERM VOLTAGE MOVING AVERAGE DIFFERENCE OF EACH BATTERY CELL ~810

CALCULATE VOLTAGE DIAGNOSIS DEVIATION OF EACH BATTERY CELL ~815

CALCULATE FIRST MOVING AVERAGE CORRESPONDING TO SHORT-TERM MOVING AVERAGE OF VOLTAGE DIAGNOSIS DEVIATION OF EACH BATTERY CELL ~820

CALCULATE SECOND MOVING AVERAGE CORRESPONDING TO LONG-TERM MOVING AVERAGE OF VOLTAGE DIAGNOSIS DEVIATION OF EACH BATTERY CELL ~825

CALCULATE LONG-SHORT TERM MOVING AVERAGE DIFFERENCE CORRESPONDING TO DIFFERENCE BETWEEN FIRST MOVING AVERAGE AND SECOND MOVING AVERAGE, FOR EACH BATTERY CELL ~830

CALCULATE MOVING AVERAGE DIAGNOSIS VALUE OF EACH BATTERY CELL ~835

840
NO ◇ HAS DIAGNOSIS TIME ELAPSED? ◇
YES

DIAGNOSE VOLTAGE ABNORMALITY OF EACH BATTERY CELL BASED ON MOVING AVERAGE DIAGNOSIS VALUE ~845

END

FIG.8

START

CALCULATE SOH OF EACH BATTERY CELL — 905

CALCULATE SOH DEVIATION OF EACH BATTERY CELL — 910

DIAGNOSE CAPACITY ABNORMALITY OF
EACH BATTERY CELL BASED ON
SOH MOVING AVERAGE DEVIATION — 915

END

FIG.9

```
                          ┌─────────┐
                          │  START  │
                          └────┬────┘
                               ↓
              ┌────────────────────────────────┐
              │ OBTAIN TIME-SERIES DATA OF      │~1005
              │ PLURALITY OF BATTERY CELLS      │
              └────────────────┬───────────────┘
                               ↓        1010
                          ◇─────────────◇
                   ◇────────              ──────◇      NO
                   ◇   VOLTAGE ABNORMALITY?    ◇──────────┐
                   ◇────────              ──────◇          │
                          ◇─────────────◇                  │
                               │ YES                       │
                               ↓         1015              │
                          ◇─────────────◇                  │
                   ◇────────              ──────◇   NO      │
                   ◇   CAPACITY ABNORMALITY?   ◇──────────┐ │
                   ◇────────              ──────◇          │ │
                          ◇─────────────◇                  ↓ │
                               │ YES        ┌─────────────────────┐
                               │            │ DETECT BATTERY CELL AS│~1025
                               │            │   NORMAL BATTERY CELL │
                               ↓            └───────────┬──────────┘
              ┌────────────────────────────┐           │
              │   DETECT BATTERY CELL       │~1020      │
              │ AS ABNORMAL BATTERY CELL    │           │
              └────────────────┬───────────┘           │
                               ↓←──────────────────────┘
                          ┌─────────┐
                          │   END   │
                          └─────────┘
```

FIG.10

## INTERNATIONAL SEARCH REPORT

| International application No. |
| --- |
| **PCT/KR2024/013934** |

### A. CLASSIFICATION OF SUBJECT MATTER

**G01R 31/392**(2019.01)i; **G01R 19/00**(2006.01)i; **G01R 31/3828**(2019.01)i; **G01R 19/165**(2006.01)i

According to International Patent Classification (IPC) or to both national classification and IPC

### B. FIELDS SEARCHED

Minimum documentation searched (classification system followed by classification symbols)

G01R 31/392(2019.01); B60L 3/00(2006.01); G01R 19/00(2006.01); G01R 31/36(2006.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 이상(abnormality), 전압(voltage), 검출(detect), SOH(state of health), 평균(average)

### C. DOCUMENTS CONSIDERED TO BE RELEVANT

| Category* | Citation of document, with indication, where appropriate, of the relevant passages | Relevant to claim No. |
| --- | --- | --- |
| X<br><br>A | KR 10-2023-0088014 A (LG ENERGY SOLUTION, LTD.) 19 June 2023 (2023-06-19)<br>See paragraphs [0045]-[0130] and figures 1-5. | 1,3-4,13-14<br><br>2,5-12,15 |
| A | JP 2017-227539 A (YOKOGAWA ELECTRIC CORP.) 28 December 2017 (2017-12-28)<br>See claims 1-16. | 1-15 |
| A | KR 10-2021-0050396 A (LG CHEM, LTD.) 07 May 2021 (2021-05-07)<br>See claims 1-14. | 1-15 |
| A | KR 10-2019-0011957 A (SAMSUNG ELECTRONICS CO., LTD.) 08 February 2019 (2019-02-08)<br>See claims 1-20. | 1-15 |
| A | JP 2004-031120 A (NISSAN MOTOR CO., LTD.) 29 January 2004 (2004-01-29)<br>See claims 1-16. | 1-15 |

☐ Further documents are listed in the continuation of Box C.  ☑ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **16 December 2024** | **16 December 2024** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2024/013934**

| Patent document cited in search report | | | Publication date (day/month/year) | Patent family member(s) | | | Publication date (day/month/year) |
|---|---|---|---|---|---|---|---|
| KR | 10-2023-0088014 | A | 19 June 2023 | None | | | |
| JP | 2017-227539 | A | 28 December 2017 | CN | 107526038 | A | 29 December 2017 |
| | | | | CN | 107526038 | B | 25 May 2021 |
| | | | | JP | 6477610 | B2 | 06 March 2019 |
| KR | 10-2021-0050396 | A | 07 May 2021 | None | | | |
| KR | 10-2019-0011957 | A | 08 February 2019 | US | 10753980 | B2 | 25 August 2020 |
| | | | | US | 2019-0033376 | A1 | 31 January 2019 |
| JP | 2004-031120 | A | 29 January 2004 | JP | 4019815 | B2 | 12 December 2007 |
| | | | | US | 2004-0001996 | A1 | 01 January 2004 |
| | | | | US | 7332891 | B2 | 19 February 2008 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230184929